# EUROPEAN PATENT APPLICATION

(11) **EP 4 617 800 A1**
(43) Date of publication of application: **17.09.2025**
(21) Application number: 24163471.6
(22) Date of filing: 14.03.2024
(51) Int. Cl.: G05B 19/042, G05B 23/02

(54) **METHOD FOR DETERMINING A PROBABILITY OF A VIOLATION OF SAFETY GOALS**

(71) Applicant: Robert Bosch GmbH, 70442 Stuttgart (DE)
(72) Inventor: Reisgys, Armin, 70439 Stuttgart (DE)

(57) **Abstract**

Method for determining a probability of a violation of safety goals of a technical system (21), comprising:
- providing a violated safety goal,
- deriving a Fault Tree (30) top-down from the violated safety goal to an event corresponding to a component (22) of the technical system (21) causing the violated safety goal,
- checking whether the event includes an external influence on the component's performance and/or an electrical and/or electronic fault of the component (22),
- in case of one or more electrical and/or electronic faults of a component (22) outputting a propagated probability of respective components or events,
- in case of an environmental influence on a component's performance, defining an interface to a Bayesian network (31, 38),
- defining and causally connecting nodes of environmental conditions in the Bayesian network (31, 38),
- providing quantification input on conditional dependencies into the Bayesian network (31, 38),
- providing, by the Bayesian network (31, 38), a quantification on the environmental condition influence on the component's behavior to the interface or to the Fault Tree,
- outputting the probability of a violation of a safety goal caused by environmental conditions and/or electrical and/or electronic faults in the technical system (21).

## Description

### Background

Deductive analyses are used to evaluate a system failure or a violation of a given safety goal. One of the most used methods is the Fault Tree Analysis (FTA) which is analysing the root causes of a undesired event which is located at a top gate of the Fault Tree. This undesired event is defined of the violation of a safety goal in the context of safety engineering. In the Fault Tree Analysis, the top gates i.e. violation of a safety goal are linked by a boolean algebra, using OR-/AND-/NOT-/XOR-relationships to the base events which correspond to faults in the system.

These modeled relationships are the basis for a qualitative and quantitative analysis providing statements of the violation of the safety goal. In the functional safety context of the automotive industry the base events model electrical and/or electronic (E/E) faults of the system with their relationship to the violation to the safety goal as a top gate. Hereby, the Fault Tree Analysis is limited in its evaluation by and to the boolen algebra it is using.

A different method to derive a faulty behaviour of a system are Bayesian Networks. Bayesian Networks (BN) are using nodes to describe the behaviour of a system or environmental conditions and connect the nodes of the Bayesian Network with conditional dependencies to link relationships between them. These conditional dependencies allow a more detailed statical relationship between the node as they are not limited to a boolean algebra only.

### Summary

A first aspect of the present disclosure relates to a method for determining a probability of a violation of safety goals of a technical system.

The method of the present disclosure includes
- providing a violated safety goal,
- deriving a Fault Tree top-down from the violated safety goal to an event corresponding to a component of the technical system causing the violated safety goal,
- checking whether the event includes an external influence on the component's performance and/or an electrical and/or electronic fault of the component,
- in case of one or more electrical and/or electronic faults of a component outputting a propagated probability of respective components or events,
- in case of an environmental influence on a component's performance, defining an interface to a Bayesian network,
- defining and causally connecting nodes of environmental conditions in the Bayesian network,
- providing quantification input on conditional dependencies into the Bayesian network,
- providing, by the Bayesian network, a quantification on the environmental condition influence on the component's behavior to the interface or to the Fault Tree,
- outputting the probability of a violation of a safety goal caused by environmental conditions and/or electrical and/or electronic faults in the technical system.

A second aspect of the present disclosure relates to a computer system adapted to perform the method according to the first aspect (or an embodiment thereof).

A third aspect of the present disclosure relates to a computer program adapted to perform the method according to the first aspect (or an embodiment thereof).

A fourth aspect of the present disclosure relates to a computer readable medium or signal storing and/or containing the computer program according to the third aspect (or an embodiment thereof).

The technique of the first to fourth aspects can have advantageous technical effects.

The techniques of the present disclosure may provide enhancements to the deductive derivement of the quantification of the violation of a safety goal. To argument a release of an automated driving (AD) system or of an automated driving component, safety analysis is necessary. Depending on the safety relevance of the system a deductive analysis is mandatory in the state of the art to show safety goal fulfillment for electrical and/or electronic faults. The influence of environmental conditions on the automated driving system is not the scope of a deductive functional safety (FuSa) analysis, but it is in the scope of activities according to Safety of the Intended Functionality (SOTIF). To quantify the safety relevant influence of environmental conditions on the system, a model is derived to argument the achievement of the acceptance criteria of the system.

The techniques of the present disclosure may propose the combined usage of Bayesian networks (BN) with a Fault Tree Analysis (FTA) in one deductive analysis to derive a quantitative evaluation of the violation of a safety goal of a system as an automated driving (AD) system or component. This combination of the deductive analysis has the violation of a safety goal on top of the analysis (probability of this violation is the desired evaluation result) and derives the tree top-down to lower gates in the system. When environmental conditions influence the probability of a gate in the Fault Tree Analysis e.g. sensor detection performance decreases resulting in a false-negative (FN) detection due to rain, an interface to a Bayesian network may be defined. The Bayesian network models the environmental condition influence on the performance of the system e.g. sensor detection performance decreased due to weather, Reflection, other traffic participant, etc.

The techniques of the present disclosure may have the advantage that when the Bayesian network is included in the Fault Tree Analysis, the performance of the system e.g. automated driving system and automated driving components can be modeled together with the occurrence of electrical and/or electronic faults in a single complete tree. This complete tree is used to get an overall quantification on the violation a safety goal with a root cause of an environmental condition and/or an electrical and/or electronic fault of the system. This quantificated analysis of the safety goal violation may be used to argument a release of a system e.g. an automated driving system. This may be achieved by providing an argument to archieve acceptance criteria additionally to the verification and validation activities.

The techniques of the present disclosure may provide this combined approach of using Fault Tree Analysis and Bayesian networks for the modeling of the system performance (influence of environmental conditions using Bayesian networks) and E/E-fault propagation in the system (root cause modeled in Fault Tree Analysis). Together, the two methods allow to provide a quantificated statement of the violation of safety goals of the system. Thus, the techniques of the present disclosure may by utilized as a development tool.

The techniques of the present disclosure may be used for automated driving (AD) systems and automated driving components. In the design phase of an automated driving system or a component the safety of the system must be evaluated and argumented. To derive a quantificated safety statement of the system, the (violation of) safet goals shall be analysed. To do so, influences of the environmental condition on the system (scope of SOTIF activities) and internal electrical and/or electronic faults (scope of Functional Safety (FuSa)) shall be analysed.

### Description of the Figures

Fig. 1 is a flow diagram illustrating a method for determining a probability of a violation of safety goals according to the first aspect.
Fig. 2 shows schematically a system of the present techniques.
Fig. 3 shows schematically a possible topology of a Fault Tree according to the present techniques.

### Detailed Description

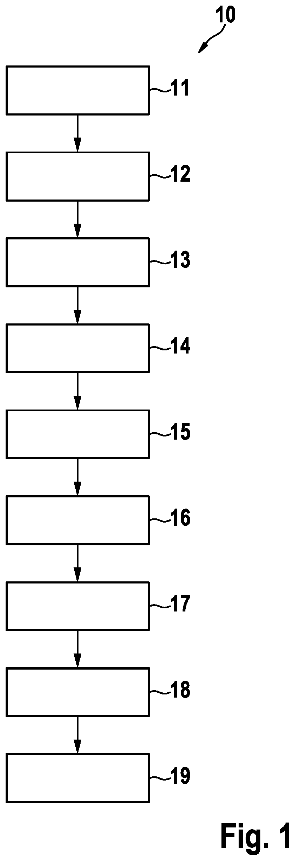

Fig. 1 discloses a method for determining a probability of a violation of safety goals of a technical system. The technical system may be or include an automated driving (AD) system such as an active breaking system or function. The method identifies and handles violation of safety goals which are based on environmental conditions and/or faults such as electrical and/or electronic (E/E) faults of components of the technical system. The method proposes a combined propability propagation and analysis in a Fault Tree and one or more Bayesian networks included in the Fault Tree.

In a first step 11, providing a violated safety goal of the technical system. More than one goal may be provided. Bayesian networks model very fuzzy events as e.g. fusion blocks in software in order to e.g. connect data from radar, video, lidar sources. Further, robotics, process environmental influences, which also work with neural networks may be used to detect, provide and/or handle safety goal violations. Violated safety goals may be derived during testing of the technical system or from a running technical system.

In a further step 12, deriving a Fault Tree top-down from the violated safety goal to an event corresponding to a component of the technical system causing the violated safety goal. Such deriving may be achieved manually by mapping the functional architecture of the system. The issue of the component of the technical system leading to the violated safety goal may stem from environmental influences on a component performance and/or from a fault of the component such as an electrical and/or electronic E/E-fault.

In a further step 13, checking whether the event includes an external influence on a component's performance and/or an fault of a component. An external influence on a component's performance may include an environmental influence on a component's behaviour. In other words, an influence originating external to the component has some impact on a function of the component which is relevant to the technical system. In an example, a sensor perceives sufficiently, correct processing in the software in a defined time frame takes place. However, e.g. a pedestrian with strange color/pattern is not detected. Such error may be caused by a wrong specification and detonates performance of the sensor and the technical system. A fault of the component may for example be an electrical and/or electronic (E/E) fault of the component.

In a further step 14, in case of one or more E/E faults of a component, outputting propagated (multiplied) probability of respective components or events. The propagated probability may be a multiplied or added probability. In case of several violated savety goals more probabilities are defined and processed. One probability may be provided for each violated savety goal.

In a further step 15, in case of an environmental influence on a component's performance, defining an interface to a Bayesian network. Then, the modeling of this environmental influence continues in the Bayesian network. The definition of of the interface may include parameter definitions, the inclusion of a Bayesian network into the Fault Tree and/or setting up communication between the Fault Tree and the Bayesian network. Further, it is possible to implement probabilities of occurrence derived from the Bayesian network into gates and/or events within the Fault Tree.

When both failures i.e. an E/E fault of the component and an environmental influence on a component's performance occur both failures may be analyzed and their respective probabilities may be combined.

In a further step 16, defining and causally connecting nodes of environmental conditions in the Bayesian network. Information for this step may be provided by experts and/or be deriving data from other analysis systems.

In a further step 17, providing quantification input on conditional dependencies into the Bayesian network. This may include data from field experiments like e.g. false negatives or false positives. Data from other data sets may be fed into the Bayesian network as well.

In a further step 18, providing, by the Bayesian network, a quantification on the environmental condition influence on the component's behavior to the interface or to the Fault Tree. The quantification may be a probability of the violation of safety goals.

In a further step 19, outputting the probability of a violation of a safety goal caused by environmental conditions and/or E/E-faults in the technical system.

Such output may be a quantificated safety statement of the technical system. This step may include combining e.g. multiplying multiple probabilities of different occurrence probabilities along a path through the Fault Tree.

The Bayesian network may provide an occurrence probability of the external influence on the component to the interface at a gate or event in the Fault Tree. Alternatively, the occurrence probability is stored at a gate or event in the Fault Tree.

The Bayesian network may be integrated into the Fault Tree. Then, information is passed between the Fault Tree and the Bayesian network, e.g. via an interface. The Bayesian network may be located at a gate or an event in the Fault Tree.

Deriving the Fault Tree may include mapping a functional architecture of the technical system into the Fault Tree. The functional architecture may be provided by experts, data about and/or analysis of the technical system.

Providing quantification input on conditional dependencies into the Bayesian network comprises may include data from field experiments and/or from other data sets into the Bayesian network.

The method 10 may include a further step of approving a safety release of the system in case the outputted probability of a violation of a safety goal is below a predefined value. The safety release may ensure that the probability of a violation of safety goals of the technical system is sufficiently low.

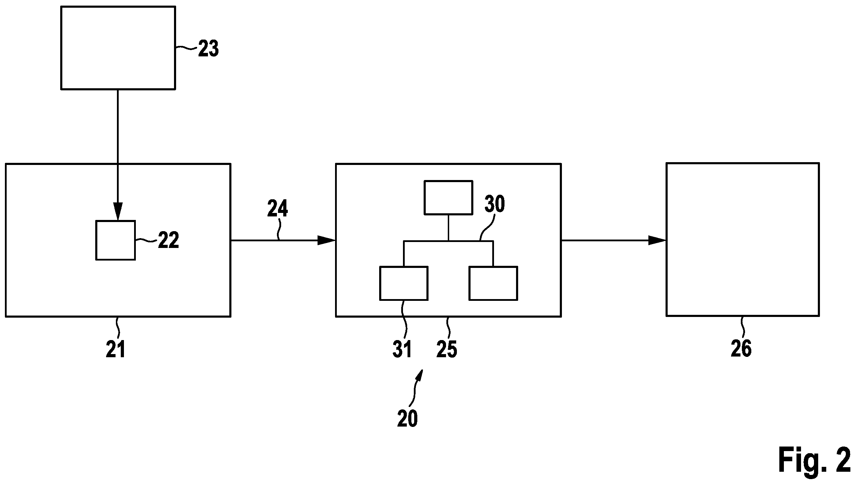

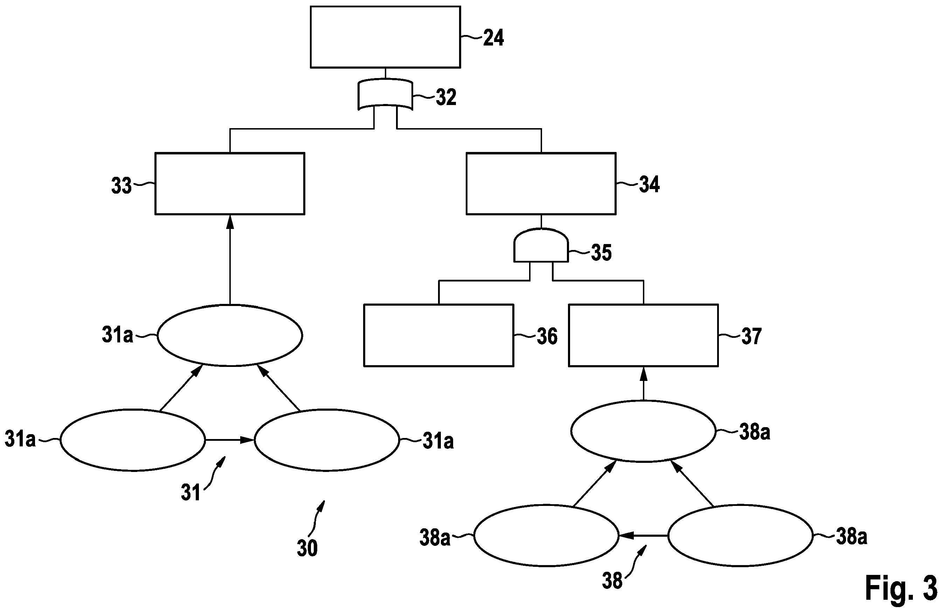

Features of the present disclosure described below in conjunction with Figs. 2 or 3 showing a computing system apply also to the method as described above.

Fig. 2 schematically shows a system 20 in which the techniques of the present disclosure can be used for determining a probability of a violation of safety goals. The system 20 may be implemented in hardware and/or software.

A system 20 includes a technical system 21 and a computing system 25. The computing system 25 is configured for determining a probability of a violation of safety goals of the technical system 21. The system 20 may be or be part of a development environment for developing, analyzing, testing and/or verifying the technical system 21.

The technical system 21 may be or include an automated driving (AD) system such as an active breaking system or function. The technical system 21 includes components which may be implemented in hardware and/or software. One component 22 e.g. a sensor is depicted as an example.

The component 22 e.g. a sensor is subjected to an environmental influence 23 e.g. a weather condition. The environmental influence 23 may target the component 22 directly like e.g. raindrops on an optical sensor. Alternatively, or additionally, the environmental influence 23 may target the component 22 indirectly like a pattern of a person's clothes preventing recognition of the person by the sensor or a software processing the sensor's output. Further, not depicted here, an internal fault of the component 22 such as an electrical and/or electronic (E/E) fault may occur.

The external or environmental influence 23 and/or the internal E/E fault may lead to a violated safety goal 24 e.g. a missed recognition of an external unit such as a car or a person. This violated safety goal 24 is provided to a computing system 25. The computing system 25 may be implemented in hardware and/or software. The computing system 25 may an analyzing unit in a design process.

The computing system 25 includes a Fault Tree 30 combined with a Bayesian network 31 for determining a probability of a violation of safety goals, here including violated safety goal 24, of a technical system 21. The computing system 25 including the combination of the Fault Tree 30 and the Bayesian network 31 is configured to execute the method 10 for determining a probability of a violation of safety goals of a technical system. The Fault Tree 30 combined with the Bayesian network 31 is explained in great detail in conjunction wihth Fig. 3 below.

A result of the execution of the Fault Tree 30 combined with the Bayesian network 31 is here a probability of a violation of a safety goal 26. The probability of violation is based on environmental conditions and/or electrical and/or electronic faults in the technical system 21. One or more components 22 of the technical system 21 have been subjected to an internal (technical fault like E/E fault) or an external (environmental condition) condition. Such condition influences the performance or function of the component 22 and of the technical system 21.

The probability of a violation of a safety goal 26 may be utilized to approve a safety release of the technical system 21 in case the outputted probability of a violation of a safety goal is below a predefined value.

Fig. 3 schematically shows a Fault Tree 30 combined with the Bayesian network 31 in which the techniques of the present disclosure can be used for determining a probability of a violation of safety goals of a technical system. The Fault Tree 30 is designed to execute the method 10 according to Fig. 1. The Fault Tree 30 may be implemented in hardware and/or software. Accordingly, the system shown in Figure 3 can be regarded as a computer program designed to execute the method 10 according to Fig. 1.

Fault tree analysis (FTA) is an approach of failure analysis in which an undesired state of a system is examined. It is a root cause analysis approach. This analysis method is used in safety and reliability analyses to understand potential causes of system failures, to identify the best ways to reduce risk and to determine event rates of a safety accident or a particular system failure. The Fault Tree 30 consists of events which are coupled by logic gates. The following description and Fig. 3 are a specific example of a Fault Tree 30. Fault Trees are designed for specific systems.

The Fault Tree 30 starts at the top with the violated safety goal 24. A second level of the Fault Tree 30 is connected via an OR-Gate 32. Accordingly, an interface 33 to a Bayesian network and a gate 34 are coupled to to the OR-Gate 32.

A Bayesian network 31 is connected to the interface 33. The Bayesian network 31 uses nodes 31a to describe the behaviour of a technical system under environmental conditions. The nodes 31a of the Bayesian network 31 are connected with conditional dependencies to link relationships between them. These conditional dependencies allow a more detailed statical relationship between the node as they are not limited to a boolean algebra only. Here, only three nodes are shown for illustration. The Bayesian network 31 may include tens, hundreds or thousands of nodes 31a.

The interface 33 passes an input from the Fault Tree 30 to the Bayesian network 31. Then, the Bayesian network 31 is executed on this input and as a result, a quantification on the environmental condition influence on the component's behavior is achieved. The quantification may be a probability value or a percentage. This result is forwarded by interface 33 from the Bayesian network 31 to the Fault Tree 30, in this case to the OR-Gate 32. This approach enhances the Fault Tree 30 with the capabilities of the Bayesian network 31.

The gate 34 is connected to an AND-Gate 35 which defines an entry to a third level of the Fault Tree 30. In the third level an event of a technical fault 36 such as an E/E fault and a further interface 37 to a further Bayesian network 31 is present. The event of a technical fault 36 and the interface 37 are connected as inputs to the AND-Gate 35.

A Bayesian network 38 is connected to the interface 37. The Bayesian network 38 uses nodes 38a to describe the behaviour of a technical system under environmental conditions. These environmental conditions may be the same as or may be different than in the Bayesian network 31. The nodes 38a of the Bayesian network 38 are connected with conditional dependencies to link relationships between them. These conditional dependencies allow a more detailed statical relationship between the node as they are not limited to a boolean algebra only. Here, only three nodes are shown for illustration. The Bayesian network 38 may include tens, hundreds or thousands of nodes 38a.

The interface 37 passes an input from the Fault Tree 30 to the Bayesian network 38. Then, the Bayesian network 38 is executed on this input and as a result, a quantification on the environmental condition influence on the component's behavior is achieved. The quantification may be a probability value or a percentage. This result is forwarded by interface 37 from the Bayesian network 38 to the Fault Tree 30, in this case to the AND-Gate 35. This approach enhances the Fault Tree 30 with the capabilities of the Bayesian network 38.

The event of a technical fault 36 such as an E/E fault includes or describes the probability of an internal technical error or fault of a component of the technical system. In other words, such technical fault occurs without an external influence. Here only one technical fault 36 is shown. The fault tree 30 may include one, tens, hundreds or thousands of technical faults as technical fault 36.

The AND-Gate 35 links both, the internal fault represented by the event of a technical fault 36 and the external fault represented by the the Bayesian network 38 together with the interface 37.

## Claims

1. Method for determining a probability of a violation of safety goals of a technical system (21), comprising:
- providing a violated safety goal,
- deriving a Fault Tree (30) top-down from the violated safety goal to an event corresponding to a component (22) of the technical system (21) causing the violated safety goal,
- checking whether the event includes an external influence on the component's performance and/or an electrical and/or electronic fault of the component (22),
- in case of one or more electrical and/or electronic faults of a component (22) outputting a propagated probability of respective components or events,
- in case of an environmental influence on a component's performance, defining an interface to a Bayesian network (31, 38),
- defining and causally connecting nodes of environmental conditions in the Bayesian network (31, 38),
- providing quantification input on conditional dependencies into the Bayesian network (31, 38),
- providing, by the Bayesian network (31, 38), a quantification on the environmental condition influence on the component's behavior to the interface or to the Fault Tree,
- outputting the probability of a violation of a safety goal caused by environmental conditions and/or electrical and/or electronic faults in the technical system (21).

2. Method according to claim 1, wherein the Bayesian network (31, 38) provides an occurrence probability of the external influence to the interface at a gate or event in the Fault Tree (30).

3. Method according to claim 1 or 2, wherein the Bayesian network (31, 38) is integrated into the Fault Tree (30).

4. Method according to one of claims 1 to 3, wherein the Bayesian network (31, 38) precalculated occurrence probabilities which are provided to and stored at gate or events in the Fault Tree (30).

5. Method according to one of claims 1 to 4, wherein deriving the Fault Tree (30) includes mapping a functional architecture of the technical system (21) into the Fault Tree (30).

6. Method according to one of claims 1 to 5, wherein providing quantification input on conditional dependencies into the Bayesian network (31, 38) comprises including data from field experiments and/or from other data sets into the Bayesian network (31, 38).

7. Method according to one of claims 1 to 6, including a further step of approving a safety release of the technical system (21) in case the outputted probability of a violation of a safety goal is below a predefined value.

8. Computing system adapted to perform the method according of any one of claims 1 to 7.

9. Computing system according to claim 8, wherein the Fault Tree (30) comprises at least one Bayesian network (31, 38).

10. Computing system according to claim 8, wherein the Fault Tree (30) comprises at least one occurrence probability stored at a gate or an event of the Fault Tree (30)and wherein the at least one occurrence probability is precalculated by a Bayesian network (31, 38).

11. Computer program adapted to perform the method according to any one of claims 1 to 7.

12. Computer readable medium or signal storing and/or containing the computer program according to claim 11.

## Amended claims

### Amended claims in accordance with Rule 137(2) EPC.

1. Method for determining a probability of a violation of safety goals of a technical system (21) comprising one or more components, comprising:
- providing a violated safety goal,
- deriving a Fault Tree (30) top-down from the violated safety goal to an event corresponding to a component (22) of the one or more components of the technical system (21) causing the violated safety goal,
- checking whether the event includes an environmental influence on the component's performance and/or an electrical and/or electronic fault of the component (22), wherein the one or more components are subjected to the environmental influence,
- in case of one or more electrical and/or electronic faults of a component (22) of the one or more components outputting a propagated probability of the respective components of the one or more components or events,
- in case of an environmental influence on a component's performance, defining an interface to a Bayesian network (31, 38),
- defining and causally connecting nodes of environmental conditions in the Bayesian network (31, 38),
- providing quantification input on conditional dependencies into the Bayesian network (31, 38),
- providing, by the Bayesian network (31, 38), a quantification on the environmental condition influence on the component's behavior to the interface or to the Fault Tree,
- outputting the probability of the violation of the safety goal caused by environmental conditions and/or electrical and/or electronic faults in the technical system (21).

2. Method according to claim 1, wherein the Bayesian network (31, 38) provides an occurrence probability of the external influence to the interface at a gate or event in the Fault Tree (30).

3. Method according to claim 1 or 2, wherein the Bayesian network (31, 38) is integrated into the Fault Tree (30).

4. Method according to one of claims 1 to 3, wherein the Bayesian network (31, 38) precalculated occurrence probabilities which are provided to and stored at gate or events in the Fault Tree (30).

5. Method according to one of claims 1 to 4, wherein deriving the Fault Tree (30) includes mapping a functional architecture of the technical system (21) into the Fault Tree (30).

6. Method according to one of claims 1 to 5, wherein providing quantification input on conditional dependencies into the Bayesian network (31, 38) comprises including data from field experiments and/or from other data sets into the Bayesian network (31, 38).

7. Method according to one of claims 1 to 6, including a further step of approving a safety release of the technical system (21) in case the outputted probability of a violation of a safety goal is below a predefined value.

8. Computing system adapted to perform the method according of any one of claims 1 to 7.

9. Computing system according to claim 8, wherein the Fault Tree (30) comprises at least one Bayesian network (31, 38).

10. Computing system according to claim 8, wherein the Fault Tree (30) comprises at least one occurrence probability stored at a gate or an event of the Fault Tree (30)and wherein the at least one occurrence probability is precalculated by a Bayesian network (31, 38).

11. Computer program adapted to perform the method according to any one of claims 1 to 7.

12. Computer readable medium or signal storing and/or containing the computer program according to claim 11.
